# EUROPÄISCHE PATENTSCHRIFT

(11) **EP 1 457 509 B1**
(45) Veröffentlichungstag und Bekanntmachung des Hinweises auf die Patenterteilung: **28.06.2006**
(21) Anmeldenummer: 03005377.1
(22) Anmeldetag: 12.03.2003
(51) Int. Cl.: C08G 59/00, C08L 63/00, C08K 3/00

(54) **Polymere Epoxidharz-Zusammensetzung**
Epoxy Resin Polymers Composition
Composition de polymère à base de résine Epoxy

(30) Priorität: 11.03.2003 EP 03005538
(43) Veröffentlichungstag der Anmeldung: 15.09.2004
(73) Patentinhaber: hanse chemie AG, 21502 Geesthacht (DE)
(72) Erfinder: Eger, Christian, Dr., 21357 Bardowick (DE); Sprenger, Stephan, Dr., 22113 Oststeinbek (DE)
(74) Vertreter: Glawe, Delfs, Moll

(56) Entgegenhaltungen:
- WO-A-00/20483
- WO-A-02/083776
- US-A- 5 686 509

## Beschreibung

Die Erfindung betrifft polymere Zusammensetzungen auf Epoxidharz-Basis. Epoxidharze werden im Stand der Technik umfangreich verwendet für Klebstoffe (heißhärtende Einkomponenten-Klebstoffe und raumtemperaturhärtende Zweikomponenten-Klebstoffe), als Harzbestandteil von Verbundwerkstoffen, insbesondere Faserverbundwerkstoffen, für sog. Coatings (Beschichtungen) und als Vergussmasse, beispielsweise für den Verguss von Elektronikbauteilen. Epoxidharze sind in ausgehärtetem Zustand in der Regel hart und spröde. Sie besitzen eine geringe mechanische Widerstandsfähigkeit insbesondere gegen schälende und schlagende Beanspruchungen. Es ist daher bereits vorgeschlagen worden (WO-A-00/20483) durch heterodispersen Einbau eines modifizierenden Copolymers auf Basis eines Carboxylgruppenhaltigen Butadienacrylnitrilkautschuks die Schlagzähigkeit von Epoxidharzen zu verbessern. US-A-5,686,509 offenbart Polymermodifizierte Epoxidharze, die Füllstoffe wie Calciumcarbonat oder Siliciumdioxid mit einen Teilchendurchmesser von 0,1 µm enthalten können.

Der Erfindung liegt die Aufgabe zugrunde, eine polymere Zusammensetzung der eingangs genannten Art zu schaffen, die gegenüber dem genannten Stand der Technik verbesserte Eigenschaften aufweist.

Die erfindungsgemäße polymere Zusammensetzung enthält folgende Bestandteile:
a) mindestens ein Epoxidharz
b) mindestens ein Copolymer mit gegenüber Epoxidharzen reaktiven Gruppen und einer Glasübergangstemperatur T_{g} von -20° C oder weniger,
c) Nanoteilchen mit einer mittels Neutronenkleinwinkelsteuerung (SANS) gemessenen mittleren Teilchengröße dₘₐₓ von 5 bis 40 nm.

Zunächst seien einige im Rahmen der Erfindung verwendete Begriffe erläutert.

Epoxidharze sind Monomere oder Prepolymere, die durchschnittlich zwei oder mehr Epoxidgruppen pro Molekül enthalten. Die Reaktion dieser Epoxidharze mit einer Reihe von bekannten Härtern führt zu vernetzten oder thermogehärteten Duroplasten. Im Rahmen der Erfindung verwendbare Epoxidharze sind beispielsweise beschrieben in Ullmanns Enzyclopedia of Industrial Chemistry, 6. Auflage, Band A12, Seite 285 ff.

Das erfindungsgemäß vorgesehene Copolymer muss reaktive Gruppen besitzen, die mit den Epoxygruppen des Epoxidharzes reagieren können und so das Copolymer chemisch in das Epoxidharz binden. Die Bezeichnung Copoplymer bedeutet in diesem Zusammenhang, dass das Polymer durch diese reaktiven Gruppen chemisch mit dem Epoxidharz reagieren kann. Dieses Copolymer mit reaktiven Gruppen kann strukturell ein Homo-oder Copolymer bzw. -oligomer sein. Das Copolymer weist eine Glasübergangstemperatur T_{g} von -20° C oder weniger auf. Es bildet in dem erfindungsgemäßen Polymer nach dessen Aushärtung sog. Kautschukdomänen, die diese genannte Glasübergangstemperatur besitzen. Bei den Kautschukdomänen handelt es sich um im wesentlichen nur das Copolymer enthaltende Phasen, die in das Epoxidharz eingelagert sind und eine Modifizierung der mechanischen Eigenschaften, insbesondere der Schlagzähigkeit, bewirken. Innerhalb dieser Kautschukdomänen können beispielsweise zwischen den Copolymermolekülen im wesentlichen lediglich van der Waals-Kräfte wirken, im Grenzbereich zur Epoxidharzmatrix erfolgt aufgrund der gegenüber Epoxiden reaktiven Gruppen ein Einpenetrieren des Copolymers in die Epoxidharzmatrix. Die erfindungsgemäße polymere Zusammensetzung ist nach ihrer Aushärtung in einem Zustand, den man als Grenzfall zwischen einem echten Zweiphasensystem (Epoxidharzmatrix mit Kautschukdomänen) und einem interpenetrierenden Netzwerk ansehen kann.

Ein weiterer Bestandteil der erfindungsgemäßen Zusammensetzung sind Nanoteilchen oder Nanopartikel mit einer mittleren Teilchengröße dₘₐₓ von 5 bis 40 nm. Als Verfahren zur Messung der mittleren Teilchengröße kommt die Neutronenkleinwinkelstreuung (SANS small angel neutron scattering) zur Anwendung. Dieses Messverfahren ist dem Fachmann geläufig und bedarf hier keiner näheren Erläuterung. Bei der SANS-Messung erhält man eine Teilchengröße-Verteilungskurve, bei der der Volumenanteil von Teilchen mit entsprechender Größe (Durchmesser) aufgetragen ist über dem Teilchendurchmesser. Als mittlere Teilchengröße wird der Peak einer solchen SANS-Verteilungskurve, also die größte Volumenfraktion mit Teilchen entsprechenden Durchmessers, definiert.

Die Erfindung beruht auf der Erkenntnis, dass die Modifizierung von Epoxidharzen mit Kautschukdomänen bildenden Copolymeren einerseits und Nanoteilchen oder -partikeln andererseits eine deutliche und unerwartete Verbesserung der mechanischen Eigenschaften einer ausgehärteten erfindungsgemäßen polymeren Zusammensetzung bewirkt. Man erhält nach der Vernetzung und Härtung Duroplaste mit erheblich verbesserter Bruch- und Schlagzähigkeit, wobei andere wichtige, für Duroplaste charakteristische Eigenschaften, wie Festigkeit, Wärmeformbeständigkeit und Chemikalienresistenz im wesentlichen unbeeinflusst erhalten bleiben. Für den Fachmann war nicht zu erwarten, dass die Kombination der für sich genommen jeweils bekannten Modifikation von Epoxidharzwerkstoffen mit Polymeren einerseits und Nanoteilchen andererseits eines synergistische Wirkung aufweist und eine deutliche Verbesserung der mechanischen Eigenschaften bewirkt.

Die Epoxidharze können beispielsweise glycidylbasierte Harze sein. Glycidylbasierte Harze sind erhältlich durch Reagierenlassen von Epichlorhydrin mit Stoffen, die wenigstens zwei reaktive Wasserstoffatome pro Molekül aufweisen. Es kann sich dabei beispielsweise um Polyphenole, Mono- und Diamine, Aminophenole, heterozyklische Imide und Amide, aliphatische Diole und Polyole und dimere Fettsäuren handeln. Unter den glycidylbasierten Epoxidharzen sind die Polyglycidylether bevorzugt. Besonders bevorzugt sind Epoxidharze auf der Basis des Diglycidylethers von Bisphenol A (DGEBA). Weiterhin verwendbar sind Epoxidharze basierend auf epoxidierten aliphatischen bzw. bevorzugt cycloaliphatischen Dienen.

Die Auswahl bevorzugter Epoxidharze hängt auch von der beabsichtigten Anwendung der erfindungsgemäßen polymeren Zusammensetzung ab, dies wird weiter unten noch näher erläutert.

Wenn im Rahmen der Erfindung von einer polymeren Zusammensetzung gesprochen wird, umfasst dieser Begriff sowohl die noch nicht vernetzte bzw. ausgehärtete Mischung der entsprechenden Bestandteile als auch einen daraus hergestellten duroplastischen Werkstoff. Bei den noch reaktionsfähigen Mischungen kann es sich sowohl um Einkomponentenmischungen handeln, die durch äußere Einflüsse zur Reaktion gebracht werden können (beispielsweise heißhärtende Einkomponentenklebstoffe) als auch um Mehrkomponentengemische, bei denen nach einer Vermischung der Komponenten die Aushärtung zum duroplastischen Werkstoff einsetzt (beispielsweise Zweikomponenten-Epoxidharzkleber).

Die Glasübergangstemperatur T_{g} der Domänen (Kautschukdomänen des Copolymers) liegt bevorzugt bei maximal -30° C, weiter vorzugsweise -40, -50 bzw. -60° C. Vorzugsweise unterschreitet sie nicht -100° C. Die bevorzugte Glasübergangstemperatur hängt auch von der beabsichtigten Anwendung der erfindungsgemäßen polymeren Zusammensetzungen ab. Bei der Anwendung als Strukturklebstoffe im Fahrzeug- oder Flugzeugbau kommt es beispielsweise auf hohe Schlagzähigkeit auch bei tiefen Temperaturen an, um eine hinreichende Festigkeit der Verklebung auch bei Unfällen (Crashsicherheit) zu gewährleisten. Gängige Prüftemperaturen für die Festigkeit von Strukturverklebungen im Automobilbau sind beispielsweise -40° C, im Flugzeugbau -60° C.

Der Anteil des Copolymers an der erfindungsgemäßen polymeren Zusammensetzung beträgt bevorzugt 2 bis 30 Gew.-%, weiter vorzugsweise 4 bis 18 Gew.-%. Die Copolymere sind in der Regel nicht ohne weiteres mit dem Epoxidharz mischbar. Bei der Herstellung einer erfindungsgemäßen Zusammensetzung werden daher in der Regel zunächst durch chemische Umsetzung der Copolymere mit einem Überschuss Epoxidharz sog. Addukte oder Prepolymere hergestellt. Diese Addukte sind mit allen gängigen Epoxidharzen beliebig mischbar. Im Rahmen der Erfindung ist es also nicht erforderlich, dass das Copoplymer beim Vermischen mit den übrigen Bestandteilen der polymeren Zusammensetzung noch reaktive Gruppen aufweist. Vielmehr ist es bevorzugt, diese reaktiven Gruppen bereits in einer Vorstufe mit einem Teil des Epoxidharzes abreagieren zu lassen, wobei dieser Epoxidharzanteil einen molaren Überschuss von Epoxygruppen gegenüber den reaktiven Gruppen gegenüber den reaktiven Gruppen des Copolymers aufweist. Gegenstand der Erfindung ist somit eine polymere Zusammensetzung gemäß der Definition des Anspruchs 1 unabhängig davon, in welcher Reihenfolge diese Bestandteile zusammengegeben und gegebenenfalls reagieren gelassen werden und ob dies einstufig oder in mehreren aufeinanderfolgenden Verfahrensschritten erfolgt. Während der Härtung einer erfindungsgemäßen Zusammensetzung tritt dann eine Phasentrennung auf und es bilden sich in der Epoxidharzmatrix die bereits beschriebenen Kautschukdomänen aus, welche über die Epoxidendgruppen chemisch in die Matrix eingebunden sind.

Die Kautschukdomänen in der ausgehärteten Zusammensetzung besitzen vorzugsweise eine mittlere Größe bestimmt durch REM oder TEM von 0,05 bis 20 µm, weiter vorzugsweise 0,1 bis 10 µm, weiter vorzugsweise 0,2 bis 4 µm.

Beispiele für die Copolymeren sind 1,3-Dienpolymere mit Carboxylgruppen und weiteren polaren ethylenisch ungesättigten Comonomeren. Als Dien kann dabei Butadien, Isopren oder Chloropren eingesetzt werden, bevorzugt ist Butadien. Beispiele für polare, ethylenische ungesättigte Comonomere sind Acrylsäure, Methacrylsäure, niedere Alkylester der Acryl- oder Methacrylsäure, beispielsweise deren Methyl- oder Ethylester, Amide der Acryl- oder Methacrylsäure, Fumarsäure, Itakonsäure, Maleinsäure oder deren niedere Alkylester oder Halbester, oder Maleinsäure- oder Itakonsäureanhydrid, Vinylester wie beispielsweise Vinylacetat oder insbesondere Acrylnitril oder Methacrylnitril. Ganz besonders bevorzugte Copolymere sind Carboxyl-terminierte Butadienacrylnitrilcopolymere (CTBN), oder aminofunktionelle Butadienacrylnitrilcopolymere (ATBN) die in flüssiger Form unter dem Handelsnamen Hycar von der Firma Noveon (früher B.F.Goodrich) angeboten werden. Diese haben Molekulargewichte zwischen 2000 und 5000 und Acrylnitrilgehalte zwischen 10% und 30%. Konkrete Beispiele sind Hycar CTBN 1300 X 8, 1300 X 13, 1300 X 18 oder ATBN 1300 X 16.

Im Rahmen der Erfindung sind zur Aushärtung des Epoxidharzes bekannte und dem Fachmann geläufige Härtungssysteme vorgesehen.

Als thermisch aktivierbare oder latente Härter für das Epoxidharz können bspw. Guanidine, substituierte Guanidine, substitutierte Harnstoffe, Melaminharze, Guanamin-Derivate, cyclische tertiäre Amine, aromatische Amine und/oder deren Mischungen eingesetzt werden. Dabei können die Härter sowohl stöchiometisch mit in die Härtungsreaktion einbezogen sein, sie können jedoch auch katalytisch wirksam sein. Beispiele für substituierte Guanidine sind Methylguanidin, Dimethylguanidin, Trimethylguanidin, Tetramethylguanidin, Methylisobiguanidin, Dimethylisobiguanidin, Tetramethylisobiguanidin, Hexamethylisobiguanidin, Hepamethylisobiguanidin und ganz besonders Cyanoguanidin (Dicyandiamid). Als Vertreter für geeignete Guanamin-Derivate seien alkylierte Benzoguanamin-Harze, Benzoguanamin-Harze oder Methoximethylethoxymethylbenzoguanamin genannt. Für hitzehärtende Einkomponenten-Pastenklebstoffe ist Dicyandiamid geeignet. Damit ist eine gute Lagerstabilität der Zusammensetzung gewährleistet.

Zusätzlich oder anstelle von den vorgenannten Härtern können katalytisch wirksame substituierte Harnstoffe eingesetzt werden. Dies sind insbesondere der p-Chlorphenyl-N, N-dimethylharnstoff (Monuron), 3-Phenyl-1, 1-Dimethylharnstoff (Fenuron) oder 3,4-Dichlorphenyl-N, N-dimethylharnstoff (Diuron). Prinzipiell können auch katalytisch wirksame tertiäre Acryl- oder Alkyl-Amine, wie beispielsweise das Benzyldimethylamin, Tris(dimethylamino)phenol, Piperidin oder Piperidinderivate eingesetzt werden. Weiterhin können diverse, vorzugsweise feste Imidazolderivate als katalytisch wirksame Beschleuniger oder Alleinhärter eingesetzt werden. Stellvertretend genannt seien 2-Ethyl-2-methylimidazol, N-Butylimidazol, Benzimidazol sowie N-C₁ bis C₁₂-Alkylimidazole oder N-Arylimidazole. Weiterhin können die erfindungsgemäßen Zusammensetzungen gängige weitere Hilfs- und Zusatzmittel wie z.B. Weichmacher, Reaktivverdünner, Rheologie-Hilfsmittel, Netzmittel, Alterungsschutzmittel, Stabilisatoren und/oder Farbpigmente enthalten.

Die erfindungsgemäßen Zusammensetzungen lassen sich als einkomponentige Klebstoffe formulieren, wobei diese sowohl als hochviskose warm applizierbare Klebstoffe formuliert werden können als auch als thermisch härtbare Schmelzklebstoffe.

Die erfindungsgemäßen Zusammensetzungen können auch als zweikomponentige Epoxy-Klebstoffe formuliert werden, bei denen die beiden Reaktionskomponenten erst kurz vor der Applikation miteinander vermischt werden, wobei die Aushärtung dann bei Raumtemperatur oder mäßig erhöhter oder erniedrigter Temperatur stattfindet. Als zweite Reaktionskomponente können hierbei die für zweikomponentige Epoxy-Klebstoffe an sich bekannten Reaktionskomponenten eingesetzt werden können, beispielsweise Di- oder Polyyamine, aminoterminierte Polyalkylenglykole (z.B. Jeffamine, Amino-Poly-THF) oder Polyaminoamide. Weitere Reaktivpartner können mercaptofunktionelle Prepolymere sein wie z.B. die flüssigen Thiokol-Polymere. Grundsätzlich können die erfindungsgemäßen Epoxyzusammensetzungen auch mit Carbonsäureanhydriden als zweiter Reaktionskomponente ausgehärtet werden.

Der Anteil des Härters bezogen auf die Gesamtmenge von Epoxidharz und Härter kann bevorzugt zwischen 4 und 50 Gew.-% liegen.

Die Nanoteilchen sind bevorzugt ausgewählt aus der Gruppe bestehend aus Siliciumdioxiden, Carbonaten (beispielsweise Kreiden) und Montmorillonit. Besonders bevorzugt sind Siliciumdioxidnanoteilchen, wie sie in der WO-A-02/083776 offenbart sind. Bevorzugt sind die Nanoteilchen oberflächenmodifiziert, um deren Agglomeration zu verhindern oder verringern und den Einbau in die Harzmatrix zu erleichtern. Bei Siliciumdioxiden ist eine bevorzugte Oberflächenmodifikation die Silanisierung mit geeigneten Silanen.

Die Silane können hydrolysierbare und nicht hydrolysierbare, ggf. funktionelle Gruppen aufweisen. Beispiele für hydrolysierbare Gruppen sind Halogen-, Alkoxy-, Alkenoxy-, Acylox-, Oximino- und Aminogruppen. Beispiele für funktionelle, nicht hydrolysierbare Gruppen sind Vinyl-, Aminopropyl-, Chlorpropyl-, Aminoethylaminopropyl-, Glycidyloxypropyl-, Mercaptopropyl- oder Methacryloxypropyl-Gruppen. Beispiele für nicht hydrolisierbare, nicht funktionelle Gruppen sind einwertige C₁- bis C₈-Kohlenwasserstoffreste. Beispiele für erfindungsgemäß verwendbare Silane sind: γ-Aminopropyltrimethoxysilan, γ-Aminopropylmethyldiethoxysilan, γ-Amino-Propyldimethylmethoxysilan, Glycidyloxypropyltrimethoxysilan, Methacryloxypropyltrimethoxysilan, Chlorpropyltrimethoxysilan, Vinylmethyldimethoxysilan, Vinyltrispropenoxysilan, Vinyldimethylbutanoximsilan, Vinyltrisbutanonoximsilan, Trimethylchlorsilan, Vinyldimethylchlorsilan, Dimethylchlorsilan, Vinylmethylchlorsilan.

Die Silane werden bevorzugt in einer Konzentration von 40 bis 200 Mol-% und besonders bevorzugt von 60 bis 150 Mol-% bezogen auf die molare Menge Silanolgruppen auf der Oberfläche der Nanoteilchen eingesetzt.

Die mittlere Teilchengröße dₘₐₓ der Nanoteilchen liegt bevorzugt zwischen 6 und 40 nm, weiter vorzugsweise 8 und 30 nm, vorzugsweise 10 und 25 nm. Die maximale Halbwertsbreite der Verteilungskurve der Teilchengröße der Nanoteilchen beträgt vorzugsweise maximal 1,5 dₘₐₓ, weiter vorzugsweise maximal 1,2 dₘₐₓ weiter vorzugsweise maximal 0,75 dₘₐₓ. Die Halbwertsbreite der verteilungskurve ist die Breite (in nm) der Verteilungskurve auf halber Höhe, also bei der Hälfte des Teilchenvolumenanteils bei dem Verteilungskurvenpeak dₘₐₓ oder (anders ausgedrückt) die Breite der Verteilungskurve auf halber Höhe der Y-Achse (relativ zur Höhe der Kurve bei dₘₐₓ).

Die Nanoteilchen können eine mono- oder multimodale Verteilungskurve aufweisen. Bei einer monomodalen Verteilungskurve weist diese lediglich ein Maximum auf. Eine multimodale Verteilungskurve weist zwei oder mehr Maxima auf, innerhalb des genannten Bereichs von 5 bis 150 nm gibt es also zwei oder mehr Maxima dₘₐₓ der Kurve. Unter den Nanoteilchen mit multimodalen Verteilungskurven sind Teilchen mit bi- oder trimodaler Verteilungskurve bevorzugt. Bei multimodalen Verteilungskurven wird die Breite der Halbwertskurve für jedes Maximum separat bestimmt.

Gegenstand der Erfindung ist ferner ein Klebstoff, der eine erfindungsgemäße polymere Zusammensetzung enthält. Weiter oben sind Ein- und Zweikomponenten-Epoxidharzklebstoffe sowie deren mögliche Verwendung insbesondere für Strukturverklebungen im Fahrzeug- und Flugzeugbau bereits erläutert worden. Bei Klebstoffen werden die Epoxidharze bevorzugt ausgewählt aus der Gruppe bestehend aus Bisphenol A und Bisphenol F basierten Harzen. Der Anteil der Nanoteilchen an der polymeren Zusammensetzung beträgt bei Klebstoffen bevorzugt 0,5 bis 5 Gew.-%, weiter vorzugsweise 1 bis 3 Gew.-%. Es hat sich herausgestellt, dass erfindungsgemäße Klebstoffe mit Nanoteilchengehalten von deutlich über 2 Gew.-% keine signifikante Verbesserung der Schlagzähigkeit (gemessen durch Zugscherversuche nach DIN 55283) mehr erreichen.

Gegenstand der Erfindung sind ferner Verbundwerkstoffe, die erfindungsgemäße polymere Zusammensetzungen enthalten. Es handelt sich insbesondere um Faserverbundwerkstoffe wie Glasfaser- oder Kohlefaserverbundwerkstoffe. Die polymere Zusammensetzung der Erfindung ist in einem solchen Verbundwerkstoff das Imprägnierharz. Das Imprägnierharz ist das Matrixharz, in dem die Fasern oder Gewebe eingebettet sind, unabhängig von dem Einbettungsverfahren. Aufgrund der sehr geringen Teilchengröße der Nanoteilchen kann eine erfindungsgemäße polymere Zusammensetzung als Imprägnierharz problemlos auch in dichtgepackte Verstärkungsfasern, wie sie für hoch beanspruchte Verbundwerkstoffe vorgesehen sind, eindringen. Damit können sich die vorteilhaften mechanischen Eigenschaften der erfindungsgemäßen Zusammensetzung im gesamten Bauteil entfalten. Für die Verwendung im Rahmen von Verbundwerkstoffen sind die Epoxidharze bevorzugt ausgewählt aus der Gruppe bestehend aus Bisphenol A und Bisphenol F basierten Harzen, Novolakharzen und aromatischen Glycidylaminen. Der Anteil der Nanoteilchen an der polymeren Zusammensetzung beträgt bevorzugt 3 bis 20 Gew.-%, weiter vorzugsweise 6 bis 10 Gew.-%. Erfindungsgemäße Verbundwerkstoffe können bspw. zur Herstellung von Leiterplatten, Strukturbauteilen für Fahrzeuge und Flugzeuge, Sportgeräte, Radarmasten, Windmühlenflügeln oder dergleichen verwendet werden.

Ein weiterer Gegenstand der Erfindung sind Coatings, die eine erfindungsgemäße polymere Zusammensetzung enthalten. Solche Coatings können beispielsweise Farben, Lacke oder sonstige Beschichtungen sein. Bei Coatings wirkt sich besonders vorteilhaft aus, dass durch den Gehalt an Nanoteilchen die Abrieb- und Kratzfestigkeit sowie die Sperrwirkung gegen die Penetration der Beschichtung durch Gase und Feuchtigkeit erhöht werden. Für die Verwendung bei Coatings werden die Epoxidharze der erfindungsgemäßen polymeren Zusammensetzung bevorzugt ausgewählt aus der Gruppe bestehend aus Bisphenol A und Bisphenol F basierten Harzen sowie epoxidierten Cycloaliphaten. Der Anteil der Nanoteilchen an der polymeren Zusammensetzung beträgt bevorzugt 10 bis 50 Gew.-%, weiter vorzugsweise 20 bis 50 Gew.-%.

Gegenstand der Erfindung sind ferner Vergussmassen, die eine erfindungsgemäße polymere Zusammensetzung enthalten. Vergussmassen werden in der Elektro- und Elektronikindustrie als E-lektroisolierharze beispielsweise beim Verguss von Spulen oder Transformatoren verwendet oder als sog. Die-Attach-Klebstoff zum Verkleben von Bauteilen auf Leiterplatten eingesetzt. Beim Verguss von Spulen kommt es darauf an, dass die Vergussmasse (das Imprägnierharz) möglichst leicht und fehlerfrei durch die oft nur wenige µm großen Abstände der Spulenwicklungen fließen kann. Dies ist bei den nanogefüllten polymeren Zusammensetzungen der Erfindung problemlos möglich. Für die Verwendung im Rahmen von Vergussmassen werden die Epoxidharze bevorzugt ausgewählt aus der Gruppe bestehend aus Bisphenol A und Bisphenol F basierten Harzen sowie der epoxidierten Cycloaliphaten. Der Anteil der Nanoteilchen an der polymeren Zusammensetzung beträgt bevorzugt 10 bis 50 Gew.-%, weiter vorzugsweise 20 bis 50 Gew.-%.

Gegenstand der Erfindung ist somit auch die Verwendung einer erfindungsgemäßen polymeren Zusammensetzung zur Herstellung eines Produktes ausgewählt aus der Gruppe bestehend aus Klebstoffen, Verbundwerkstoffen, Coatings und Vergussmassen.

Die Erfindung wird nachfolgend anhand von Beispielen erläutert.

### Beispiele 1 und 2

Formulierung heißhärtender Einkomponenten-Klebstoffe.

Heißhärtende Einkomponentenklebstoffe wurden gemäß der Rezeptur der nachfolgenden Tabelle 1 eingesetzt. Die Zahlenangaben in der Tabelle sind Gewichtsanteile. Beispiel 1 und 2 sind erfindungsgemäße Beispiele, Kontrolle 1 ist ein Epoxidharz, Kontrolle 2 ein Epoxidharz mit einem CTBN-Copolymer

**Tabelle 1**

| | Kont 1 | Kont 2 | Bspl. 1 | Bspl. 2 |
|---|---|---|---|---|
| DGEBA | 100 | 77,5 | 73,7 | 76,0 |
| Nano-Addukt | - | - | 43,8 | 40,0 |
| Albipox 2000 | - | 37,5 | - | - |
| Cabot TS 720 | 2 | 2 | 2 | 2 |
| Dyhard 100 SF | 4 | 4 | 4 | 4 |
| Dyhard UR 300 | 2 | 2 | 2 | 2 |
| Gew.-% Nanoteilchen | 0 | 0 | 2,0 | 0,81 |

DGEBA: Diglycidylether des Bisphenol A
Nanoaddukt: monomodales SiO₂ mit einer dₘₐₓ von 20 nm in einem Addukt aus DGEBA-Epoxidharz und dem CTBN-Kautschuk Hycar 1300 X 13.
- Albipox 2000:: Kautschukmodifiziertes Epoxidharz, Harzbasis DGEBA, NBR-Kautschukgehalt 40% (Fa. hanse chemie GmbH
- Cabot TS 720:: Pyrogene Kieselsäure als Thixotropiermittel
- Dyhard 100 SF:: Heißhärter auf Basis Dicyandiamid
- Dyhard UR 300:: Härtungsbeschleuniger auf Basis Monuron (p-Chlorphenyl-N,N-Dimethylharnstoff)

### Beispiele 3 und 4

Zweikomponentenklebstoffe

Zweikomponentenklebstoffe wurden gemäß den Rezepturen der Tabelle 2 angesetzt. Die Zahlenangaben in der Tabelle sind Masseteile. Die Beispiele 3 und 4 sind erfindungsgemäße Beispiele, Kontrolle 3 ist ein Vergleichsbeispiel ohne Nanoteilchen.

**Tabelle 2**

| | Kont 3 | Bspl. 3 | Bspl. 4 |
|---|---|---|---|
| Komponente A | | | |
| DGEBA | 100 | 92,5 | 96,25 |
| Nanopox | - | 12,5 | 6,25 |

| Komponente B | | | |
|---|---|---|---|
| Polypox P 502 | 91,5 | 88,9 | 90,4 |
| Hycar 1300x16 | 45,8 | 44,5 | 45,2 |
| Gew.-% Nanoteilchen | 0 | 2,1 | 1,05 |

- Nanopox:: 40 Gew.-% Nano-SiO₂ mit einer dₘₐₓ von 20 nm in DGEBA.
- Polypox P 502 (Hersteller UPPC): Härter auf Basis Isophorondiamin
- Hycar 1300 X 16:: ATBN erhältlich von der Firma Noveon

### Beispiel 5

### Zugscherfestigkeitsversuche

Die Einkomponentenklebstoffe der Tabelle 1 bzw. die Komponenten A und B der Zweikomponentenklebstoffe der Tabelle 2 wurden für Zugscherversuche nach DIN 55283 auf unbehandeltes Aluminium aufgetragen. Die Dicke der Klebschicht wurde mittels Glasperlen auf 0,5 mm eingestellt. Die Klebstoffe der Tabelle 1 wurde 1 Stunde bei 120°C und anschließend zwei Stunden bei 180°C gehärtet. Die Zweikomponentenklebstoffe der Tabelle 2 wurden 24 Stunden bei Raumtemperatur und zwei Stunden bei 60°C gehärtet.

Folgende Zugscherfestigkeiten (gemessen in MPa) wurden ermittelt:
- Kontrolle 1:: 10,9
- Kontrolle 2:: 16,7
- Beispiel 1:: 18,3
- Beispiel 2:: 20,1
- Kontrolle 3:: 13,4
- Beispiel 3:: 17,8
- Beispiel 4:: 19,2

## Patentansprüche

1. Polymere Zusammensetzung, die enthält:
a) mindestens ein Epoxidharz,
b) mindestens ein Copolymer mit gegenüber Epoxiden reaktiven Gruppen und einer Glasübergangstemperatur T_{g} von -20°C oder weniger,
c) Nanoteilchen mit einer mittels Neutronenkleinwinkelstreuung (SANS) gemessenen mittleren Teilchengröße dₘₐₓ von 5 bis 40 nm.

2. Zusammensetzung nach Anspruch 1, **dadurch gekennzeichnet, daß** die Epoxidharze ausgewählt sind aus der Gruppe bestehend aus Polyglycidylethern und epoxidierten Cycloaliphaten.

3. Zusammensetzung nach Anspruch 1 oder 2, **dadurch gekennzeichnet, daß** die Glasübergangstemperatur T_{g} des Copolymers -20 bis -100°C, vorzugsweise -30 bis - 100°C, weiter vorzugsweise -40 bis -100°C, weiter vorzugsweise -50 bis -100°C, weiter vorzugsweise -60 bis -100°C beträgt.

4. Zusammensetzung nach einem der Ansprüche 1 bis 3, **dadurch gekennzeichnet, daß** der Anteil des Copolymers an der Zusammensetzung 2 bis 30 Gew.-%, vorzugsweise 4 bis 18 Gew.-% beträgt.

5. Zusammensetzung nach einem der Ansprüche 1 bis 4, **dadurch gekennzeichnet, daß** das Copolymer in der ausgehärteten Zusammensetzung Kautschukdomänen mit einer mittleren Größe von 0,05 bis 20 µm, vorzugsweise 0,1 bis 10 µm, weiter vorzugsweise 0,2 bis 4 µm bildet.

6. Zusammensetzung nach einem der Ansprüche 1 bis 5, **dadurch gekennzeichnet, daß** das Copolymer ein Carboxyterminiertes Butadienacrylnitril (CTBN) ist.

7. Zusammensetzung nach einem der Ansprüche 1 bis 6, **dadurch gekennzeichnet, daß** die Nanoteilchen ausgewählt sind aus der Gruppe bestehend aus Siliciumdioxiden, Carbonaten und Montmorillonit.

8. Zusammensetzung nach einem der Ansprüche 1 bis 7, **dadurch gekennzeichnet, daß** die mittlere Teilchengröße dₘₐₓ der Nanoteilchen zwischen 6 und 40 nm, vorzugsweise 8 und 30 nm, weiter vorzugsweise 10 und 25 nm liegt.

9. Zusammensetzung nach einem der Ansprüche 1 bis 8, **dadurch gekennzeichnet, daß** die maximale Halbwertsbreite der Verteilungskurve der Teilchengröße der Nanoteilchen maximal 1,5 dₘₐₓ, vorzugsweise maximal 1,2 dₘₐₓ, weiter vorzugsweise maximal 0,75 dₘₐₓ beträgt.

10. Zusammensetzung nach einem der Ansprüche 1 bis 9, **dadurch gekennzeichnet, daß** die Nanoteilchen eine mono-oder multimodale Verteilungskurve aufweisen.

11. Zusammensetzung nach Anspruch 10, **dadurch gekennzeichnet, daß** die Verteilungskurve mono-, bi- oder trimodal ist.

12. Klebstoff, **dadurch gekennzeichnet, daß** er eine polymere Zusammensetzung nach einem der Ansprüche 1 bis 11 enthält.

13. Klebstoff nach Anspruch 12, **dadurch gekennzeichnet, daß** die Epoxidharze ausgewählt sind aus der Gruppe bestehend aus Bisphenol A- und Bisphenol F-basierten Harzen.

14. Klebstoff nach Anspruch 12 oder 13, **dadurch gekennzeichnet, daß** der Anteil der Nanoteilchen an der polymeren Zusammensetzung 0,5 bis 5 Gew.-%, vorzugsweise 1 bis 3 Gew.-% beträgt.

15. Verbundwerkstoff, **dadurch gekennzeichnet, daß** er eine polymere Zusammensetzung nach einem der Ansprüche 1 bis 11 enthält.

16. Verbundwerkstoff nach Anspruch 15, **dadurch gekennzeichnet, daß** die Epoxidharze ausgewählt sind aus der Gruppe bestehend aus Bisphenol A- und Bisphenol F-basierten Harzen, Novolakharzen und aromatischen Glycidylaminen.

17. Verbundwerkstoff nach Anspruch 15 oder 16, **dadurch gekennzeichnet, daß** der Anteil der Nanoteilchen an der polymeren Zusammensetzung 3 bis 20 Gew.-%, vorzugsweise 6 bis 10 Gew.-% beträgt.

18. Coating, **dadurch gekennzeichnet, daß** es eine polymere Zusammensetzung nach einem der Ansprüche 1 bis 11 enthält.

19. Coating nach Anspruch 18, **dadurch gekennzeichnet, daß** die Epoxidharze ausgewählt sind aus der Gruppe bestehend aus Bisphenol A- und Bisphenol F-basierten Harzen, sowie epoxidierten Cycloaliphaten.

20. Coating nach Anspruch 18 oder 19, **dadurch gekennzeichnet, daß** der Anteil der Nanoteilchen an der polymeren Zusammensetzung 10 bis 50 Gew.-%, vorzugsweise 20 bis 50 Gew.-% beträgt.

21. Vergußmasse, **dadurch gekennzeichnet, daß** sie eine polymere Zusammensetzung nach einem der Ansprüche 1 bis 11 enthält.

22. Vergußmasse nach Anspruch 21, **dadurch gekennzeichnet, daß** die Epoxidharze ausgewählt sind aus der Gruppe bestehend aus Bisphenol A- und Bisphenol F-basierten Harzen.

23. Vergußmasse nach Anspruch 21 oder 22, **dadurch gekennzeichnet; daß** der Anteil der Nanoteilchen an der polymeren Zusammensetzung 10 bis 50 Gew.-%, vorzugsweise 20 bis 50 Gew.-% beträgt.

24. Verwendung einer polymeren Zusammensetzung nach einem der Ansprüche 1 bis 11 zur Herstellung eines Produktes ausgewählt aus der Gruppe bestehend aus Klebstoffen, Verbundwerkstoffen, Coatings und Vergußmassen.

## Claims

1. Polymeric composition comprising:
a) at least one epoxy resin,
b) at least one copolymer having epoxide-reactive groups and a glass transition temperature T_{g} of -20°C or less,
c) nanoparticles having an average particle size dₘₐₓ as measured by means of small-angle neutron scattering (SANS) of 5 to 40 nm.

2. Composition according to Claim 1, **characterized in that** the epoxy resins are selected from the group consisting of polyglycidyl ethers and epoxidized cycloaliphatics.

3. Composition according to Claim 1 or 2, **characterized in that** the glass transition temperature T_{g} of the copolymer is -20 to -100°C, preferably -30 to -100°C, more preferably -40 to -100°C, more preferably -50 to -100°C, more preferably -60 to -100°C.

4. Composition according to any one of Claims 1 to 3, **characterized in that** the fraction of the copolymer as a proportion of the composition is 2% to 30% by weight, preferably 4% to 18% by weight.

5. Composition according to any one of Claims 1 to 4, **characterized in that** in the cured composition the copolymer forms rubber domains having an average size of 0.05 to 20 µm, preferably 0.1 to 10 µm, more preferably 0.2 to 4 µm.

6. Composition according to any one of Claims 1 to 5, **characterized in that** the copolymer is a carboxy-terminated butadiene-acrylonitrile (CTBN).

7. Composition according to any one of Claims 1 to 6, **characterized in that** the nanoparticles are selected from the group consisting of silicon dioxides, carbonates, and montmorillonite.

8. Composition according to any one of Claims 1 to 7, **characterized in that** the average particle size dₘₐₓ of the nanoparticles is between 6 and 40 nm, preferably 8 and 30 nm, more preferably 10 and 25 nm.

9. Composition according to any one of Claims 1 to 8, **characterized in that** the maximum width at half peak height of the distribution curve of the particle size of the nanoparticles is not more than 1.5 dₘₐₓ, preferably not more than 1.2 dₘₐₓ, more preferably not more than 0.75 dₘₐₓ.

10. Composition according to any one of Claims 1 to 9, **characterized in that** the nanoparticles have a monomodal or multimodal distribution curve.

11. Composition according to Claim 10, **characterized in that** the distribution curve is monomodal, bimodal or trimodal.

12. Adhesive, **characterized in that** it comprises a polymeric composition according to any one of Claims 1 to 11.

13. Adhesive according to Claim 12, **characterized in that** the epoxy resins are selected from the group consisting of bisphenol A- and bisphenol F-based resins.

14. Adhesive according to Claim 12 or 13, **characterized in that** the fraction of the nanoparticles as a proportion of the polymeric composition is 0.5% to 5% by weight, preferably 1% to 3% by weight.

15. Composite, **characterized in that** it comprises a polymeric composition according to any one of Claims 1 to 11.

16. Composite according to Claim 15, **characterized in that** the epoxy resins are selected from the group consisting of bisphenol A- and bisphenol F-based resins, novolak resins, and aromatic glycidylamines.

17. Composite according to Claim 15 or 16, **characterized in that** the fraction of the nanoparticles as a proportion of the polymeric composition is 3% to 20% by weight, preferably 6% to 10% by weight.

18. Coating, **characterized in that** it comprises a polymeric composition according to any one of Claims 1 to 11.

19. Coating according to Claim 18, **characterized in that** the epoxy resins are selected from the group consisting of bisphenol A- and bisphenol F-based resins, and also epoxidized cycloaliphatics.

20. Coating according to Claim 18 or 19, **characterized in that** the fraction of the nanoparticles as a proportion of the polymeric composition is 10% to 50% by weight, preferably 20% to 50% by weight.

21. Casting compound, **characterized in that** it comprises a polymeric composition according to any one of Claims 1 to 11.

22. Casting compound according to Claim 21, **characterized in that** the epoxy resins are selected from the group consisting of bisphenol A-and bisphenol F-based resins.

23. Casting compound according to Claim 21 or 22, **characterized in that** the fraction of the nanoparticles as a proportion of the polymeric composition is 10% to 50% by weight, preferably 20% to 50% by weight.

24. Use of a polymeric composition according to any one of Claims 1 to 11 to produce a product selected from the group consisting of adhesives, composites, coatings, and casting compounds.

## Revendications

1. Composition polymère, contenant :
a) au moins une résine époxyde,
b) au moins un copolymère ayant des groupes réactifs vis-à-vis des époxydes et une température de transition vitreuse T_{g} de -20°C ou inférieure,
c) des nanoparticules ayant une taille de particule moyenne dₘₐₓ de 5 à 40 nm, mesurée par dispersion de neutrons SANS *(small angle neutron scattering) .*

2. Composition selon la revendication 1, **caractérisée en ce que** les résines époxydes sont choisies dans le groupe constitué par les poly(éthers de glycidyle) et les composés cycloaliphatiques époxydés.

3. Composition selon la revendication 1 ou la revendication 2, **caractérisée en ce que** la température de transition vitreuse T_{g} du copolymère se situe dans la plage de -20 à -100°C, de préférence de -30 à -100°C, plus préférentiellement de -40 à -100°C, plus préférentiellement de -50 à -100°C, plus préférentiellement de -60 à -100°C.

4. Composition selon l'une des revendications 1 à 3, **caractérisée en ce que** la proportion du copolymère dans la composition est de 2 à 30% en poids, de préférence de 4 à 18% en poids.

5. Composition selon l'une des revendications 1 à 4, **caractérisée en ce que** le copolymère forme dans la composition durcie des domaines caoutchouteuse d'une taille moyenne de 0,05 à 20 µm, de préférence de 0,1 à 10 µm, plus préférentiellement de 0,2 à 4 µm.

6. Composition selon l'une des revendications 1 à 5, **caractérisée en ce que** le copolymère est un butadiéne/acrylonitrile à terminaison carboxyle (CTBN).

7. Composition selon l'une des revendications 1 à 6, **caractérisée en ce que** les nanoparticules sont choisies dans le groupe constitué par les dioxydes de silicium, les carbonates et la montmorillonite.

8. Composition selon l'une des revendications 1 à 7, **caractérisée en ce que** la taille de particule moyenne dₘₐₓ des nanoparticules se situe dans la plage de 6 à 40 nm, de préférence de 8 à 30 nm, plus préférentiellement de 10 à 25 nm.

9. Composition selon l'une des revendications 1 à 8, **caractérisée en ce que** la largeur de la valeur moyenne maximale de la courbe de distribution de la taille des nanoparticules est au maximum égale à 1,5 dₘₐₓ, de préférence au maximum égale à 1,2 dₘₐₓ, plus préférentiellement au maximum égale à 0,75 dₘₐₓ.

10. Composition selon l'une des revendications 1 à 9, **caractérisée en ce que** les nanoparticules présentent une courbe de distribution mono- ou multimodale.

11. Composition selon la revendication 10, **caractérisée en ce que** la courbe de distribution est mono-, bi- ou trimodale.

12. Adhésif, **caractérisé en ce qu'**il contient une composition polymère selon l'une des revendications 1 à 11.

13. Adhésif selon la revendication 12, **caractérisé en ce que** les résines époxydes sont choisies dans le groupe constitué par les résines à base de bisphénol A et de bisphénol F.

14. Adhésif selon la revendication 12 ou la revendication 13, **caractérisé en ce que** la proportion des nanoparticules dans la composition polymère est de 0,5 à 5% en poids, de préférence de 1 à 3% en poids.

15. Adhésif composite, **caractérisé en ce qu'**il contient une composition polymère selon l'une des revendications 1 à 11.

16. Adhésif composite selon la revendication 15, **caractérisé en ce que** les résines époxydes sont choisies dans le groupe constitué par les résines à base de bisphénol A et de bisphénol F, les résines novolaques et des glycidylamines aromatiques.

17. Adhésif composite selon la revendication 15 ou la revendication 16, **caractérisé en ce que** la proportion des nanoparticules dans la composition polymère est de 3 à 20% en poids, de préférence de 6 à 10% en poids.

18. Revêtement, **caractérisé en ce qu'**il contient une composition polymère selon l'une des revendications 1 à 11.

19. Revêtement selon la revendication 18, **caractérisé en ce que** les résines époxydes sont choisies dans le groupe constitué par les résines à base de bisphénol A et de bisphénol F ainsi que par les composés cycloaliphatiques époxydés.

20. Revêtement selon la revendication 18 ou la revendication 19, **caractérisé en ce que** la proportion des nanoparticules dans la composition polymère est de 10 à 50% en poids, de préférence de 20 à 50% en poids.

21. Masse d'imprégnation, **caractérisée en ce qu'**elle contient une composition polymère selon l'une des revendications 1 à 11.

22. Masse d'imprégnation selon la revendication 21, **caractérisée en ce que** les résines époxydes sont choisies dans le groupe constitué par des résines à base de bisphénol A et de bisphénol F.

23. Masse d'imprégnation selon la revendication 21 ou la revendication 22, **caractérisée en ce que** la proportion des nanoparticules dans la composition polymère est de 10 à 50% en poids, de préférence de 20 à 50% en poids.

24. Utilisation d'une composition polymère selon l'une des revendications 1 à 11 pour préparer un produit choisi dans le groupe constitué par des adhésifs, des adhésifs composites, des revêtements et des masses d'imprégnation.
